# EUROPEAN PATENT APPLICATION

(11) **EP 4 822 989 A1**
(43) Date of publication of application: **14.10.2026**
(21) Application number: 26170455.5
(22) Date of filing: 02.04.2026
(51) Int. Cl.: H03F 3/68, H03F 3/72, H03F 1/02, H03G 1/00

(54) **SYSTEMS AND METHODS FOR MULTI-CHANNEL SIGNAL ACQUISITION USING TIME-DIVISION MULTIPLEXING**

(30) Priority: 11.04.2025 US 202519177303
(71) Applicant: Avago Technologies International Sales Pte. Limited, Singapore 768923 (SG)
(72) Inventor: Lu, Junjie, Irvine, CA, 92620 (US); Guo, Jing, Irvine, CA, 92618 (US); Jiang, Xicheng, Irvine, CA, 92612 (US)
(74) Representative: Grünecker Patent- und Rechtsanwälte PartG mbB

(57) **Abstract**

An apparatus that includes a first stage being coupled to the input terminal to receive an input signal and configured to receive a first bias current. The apparatus further includes a second and a third stage coupled to the first stage being characterized by a first state and a second state. The first state is associated with a first power level and the second state is associated with a second power level lower than the first power level. The third stage comprises a first output and a second output, the first output being configured to provide an output signal coupled to the output terminal and the second output being coupled to the first stage. By utilizing programmable power modes and maintaining a stable bias voltage, the apparatus reduces power consumption and minimizes kickback noise by ensuring smooth switching between power levels.

## Description

### BACKGROUND

The subject technology is directed to electronic circuits.

### BACKGROUND OF THE INVENTION

In multi-channel signal acquisition systems, analog front-end (AFE) circuits play an important role in acquiring and processing signals from high-impedance sources. These systems are widely used in various applications, such as healthcare sensing, industrial monitoring, and/or scientific instrumentation, where accurate signal acquisition is beneficial for reliable system performance. In bio-signal sensing applications, such as electrocardiography (ECG), electroencephalography (EEG), and electromyography (EMG), electrodes detect small electrophysiological signals that must be amplified and processed with minimal distortion.

In various implementations, multi-channel sensing systems may employ time-division multiplexing (TDM) acquisition architectures to improve power efficiency and reduce circuit complexity. In TDM-based systems, multiple sensing channels share a single analog-to-digital converter (ADC), allowing only one channel to be active at a time, while the remaining channels are placed in a low-power or standby mode. This approach is particularly beneficial for battery-powered and wearable healthcare devices, where minimizing power consumption is a key design objective. However, it remains challenging to manage power transitions between active and standby modes without introducing artifacts into the acquired signal. When a sensing channel switches between states, voltage transients, charge injection, and kickback noise may propagate through the system, affecting the accuracy of subsequent measurements.

Various approaches have been explored to reduce power consumption and improve signal integrity in multi-channel analog front-end circuits, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a block diagram illustrating a multi-channel signal acquisition system, in accordance with various embodiments of the subject technology.
Figure 2 is a block diagram illustrating a multi-channel signal acquisition system employing time-division multiplexing (TDM), in accordance with various embodiments of the subject technology.
Figure 3 is a block diagram illustrating a signal acquisition system, in accordance with various embodiments of the subject technology.
Figure 4 is a simplified diagram illustrating a time-division multiplexing (TDM) operation with kickback effects, in accordance with various embodiments of the subject technology.
Figure 5A is a circuit diagram illustrating a multi-channel signal acquisition system, in accordance with various embodiments of the subject technology.
Figure 5B is a simplified diagram illustrating a channel-switching operation in a multi-channel signal acquisition system, in accordance with various embodiments of the subject technology.
Figure 5C is a circuit diagram illustrating kickback sources in a multi-channel signal acquisition system, in accordance with various embodiments of the subject technology.
Figure 6A is a circuit diagram illustrating a multi-channel signal acquisition system, in accordance with various embodiments of the subject technology.
Figure 6B is a simplified diagram illustrating an output switching operation in a multi-channel signal acquisition system, in accordance with various embodiments of the subject technology.
Figure 7 is a circuit diagram illustrating an amplifier, in accordance with various embodiments of the subject technology.
Figure 8A is a circuit diagram illustrating a first stage of an amplifier, in accordance with various embodiments of the subject technology.
Figure 8B is a circuit diagram illustrating a biasing circuit of a first stage, in accordance with various embodiments of the subject technology.
Figure 9 is a circuit diagram illustrating a third stage of an amplifier, in accordance with various embodiments of the subject technology.
Figure 10 is a circuit diagram illustrating an amplifier system with a pre-charging buffer, in accordance with various embodiments of the subject technology.
Figure 11 is a circuit diagram illustrating an analog front-end (AFE) circuit with a guard buffer, in accordance with various embodiments of the subject technology.

### DETAILED DESCRIPTION

The subject technology is directed to electronic circuits. In an embodiment, the subject technology provides an apparatus that includes an input terminal configured to receive an input signal. The apparatus further includes a first stage comprising a first input and a second input. The first input is coupled to the input terminal. The first stage is configured to receive a first bias current. The apparatus further includes a second stage coupled to the first stage, the second stage being characterized by a first state and a second state, the first state being associated with a first power level and the second state being associated with a second power level lower than the first power level. The apparatus further includes a third stage coupled to the second stage. The third stage comprises a first output and a second output, the second output being coupled to the second input of the first stage. The first output is configured to provide an output signal coupled to the output terminal based at least on the input signal, and the third stage is characterized by the first state and the second state. The second stage and the third stage are configured to transition between the first state and the second state in response to a control signal. By utilizing programmable power modes and maintaining a stable bias current, the apparatus reduces power consumption and minimizes kickback noise by ensuring smooth switching between power levels. There are other embodiments as well.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus comprising an input terminal configured to receive an input signal. The apparatus further comprises a first stage, which comprises a first input and a second input. The first input is coupled to the input terminal, the first stage is configured to receive a first bias current. The apparatus further comprises a second stage coupled to the first stage, the second stage being characterized by a first state and a second state. The first state is associated with a first power level, the second state is associated with a second power level, the second power level is lower than the first power level. The apparatus further comprises a third stage coupled to the second stage. The third stage comprises a first output and a second output, the second output being coupled to the second input, the first output being configured to provide an output signal based at least on the input signal, the third stage is characterized by the first state and the second state. The second stage and the third stage are configured to transition between the first state and the second state in response to a control signal.

Implementations may include one or more of the following features. The first stage comprises a first bias circuit configured to generate the first bias current based at least on a reference voltage. The second stage is configured to receive a first bias current based at least on the control signal. The apparatus further comprises a first buffer coupled to the first output and the second output, the second output being characterized by a first voltage level, the first buffer being configured to charge the first output to the first voltage level before a transition between the first state and the second state. The apparatus further comprises a second buffer coupled to the input terminal, the second buffer being configured to provide isolation between the input terminal and external components. The first output is coupled to an analog-to-digital converter (ADC).

According to another embodiment, the subject technology provides an apparatus that comprises an input terminal configured to receive an input signal. The apparatus further comprises a first stage comprising a first input and a second input, the first input being coupled to the input terminal, the first stage being configured to receive a first bias current. The apparatus further comprises a second stage coupled to the first stage, the second stage being characterized by a first state and a second state. The first state is associated with a first power level, the second state is associated with a second power level. The apparatus further comprises a third stage coupled to the second stage. The third stage comprises a first output and a second output, the second output being coupled to the second input, the first output being configured to provide an output signal based at least on the input signal. The third stage is characterized by the first state and the second state.

Implementations may include one or more of the following features. The second stage and the third stage are configured to transition between the first state and the second state in response to a control signal. The second power level is lower than the first power level. The first stage comprises a first bias circuit configured to generate the first bias current based at least on a reference voltage. The apparatus further comprises a first buffer coupled to the first output and the second output, the second output being characterized by a first voltage level, the first buffer being configured to charge the first output to the first voltage level before a transition between the first state and the second state. The apparatus further comprises a second buffer coupled to the input terminal, the second buffer being configured to provide isolation between the input terminal and external components. The first output is coupled to an analog-to-digital converter (ADC).

According to yet another embodiment, the subject technology provides an apparatus that comprises an input terminal configured to receive an input signal. The apparatus further comprises a first stage comprising a first input, the first input being coupled to the input terminal, the first stage being configured to receive a first bias current. The apparatus further comprises a second stage coupled to the first stage, the second stage being characterized by a first state and a second state. The first state is associated with a first power level, the second state is associated with a second power level, the second power level is lower than the first power level. The apparatus further comprises a third stage coupled to the second stage. The third stage comprises a first output configured to provide an output signal based at least on the input signal, the third stage is characterized by the first state and the second state.

Implementations may include one or more of the following features. The first stage further comprises a second input, the third stage further comprises a second output, the second output is coupled to the second input and configured to provide a feedback signal to the second input. The second stage is configured to transition between the first state and the second state in response to a control signal. The second stage is configured to receive a first bias current based at least on the control signal. The first stage comprises a first bias circuit configured to generate the first bias current based at least on a reference voltage. The apparatus further comprises a first buffer coupled to the first output and the second output, the second output being characterized by a first voltage level, the first buffer being configured to charge the first output to the first voltage level before a transition between the first state and the second state. The apparatus further comprises a second buffer coupled to the input terminal, the second buffer being configured to provide isolation between the input terminal and external components.

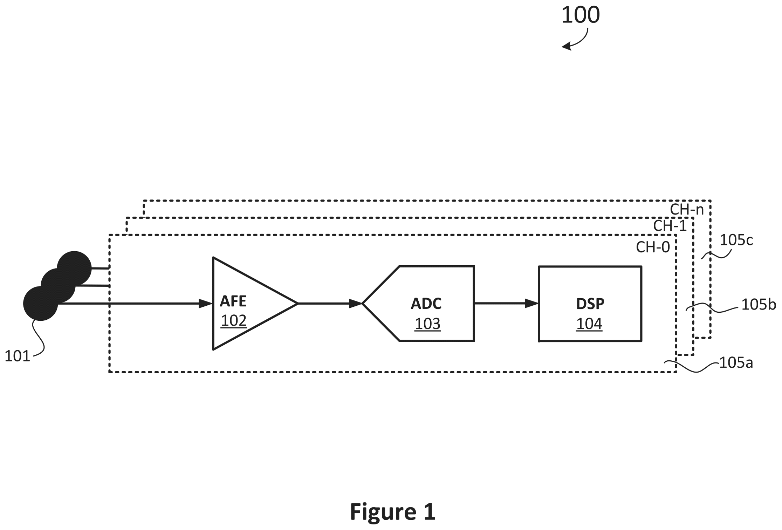

Figure 1 is a block diagram illustrating a multi-channel signal acquisition system 100, in accordance with various embodiments of the subject technology. This diagram merely provides an example, which should not unduly limit the scope of the claims. One of ordinary skill in the art would recognize many variations, alternatives, and modifications.

System 100 may be implemented in a wide range of applications that require the acquisition and processing of electrical signals, such as bio-sensing systems, industrial monitoring, environmental sensing, and/or the like. For example, in bio-sensing applications, system 100 may be used to acquire electrophysiological signals such as electrocardiography (ECG), electromyography (EMG), electroencephalography (EEG), and/or other biomedical signals for health monitoring. In these applications, system 100 may be used to acquire, condition, and/or process weak electrical signals from an external source and convert them into a digital format suitable for further analysis. These signals are typically weak, with amplitudes in the range of a few millivolts (mV) and frequencies below 1 kHz. Due to the nature of bio-sensor interfaces, system 100 must handle large DC offsets (e.g., up to 1V due to electrochemical potentials), as well as low-frequency interference from environmental sources, such as electromagnetic fields, power supply noise, and motion artifacts.

In some implementations, system 100 may employ a parallel acquisition mechanism to facilitate multi-channel signal acquisition. A multi-channel architecture enables multiple sensing paths to operate independently, allowing system 100 to capture electrophysiological signals from multiple electrodes 101 across different sensing locations. For example, system 100 may include a plurality of signal processing channels (e.g., channels 105a, 105b, 105c), each of which may include at least one of electrode 101, analog front-end (AFE) circuit 102, analog-to-digital converter (ADC) 103, processing unit 104, and/or the like. Each channel may be configured to acquire, condition, and process electrophysiological signals independently.

In various implementations, electrode 101 may be configured to interface with biological tissue to detect electrophysiological signals. Electrode 101 may include various types of electrodes, such as wet electrodes, dry electrodes, capacitive electrodes, and/or the like. For example, in wearable health monitoring applications, a dry electrode may be used due to its ease of use, long-term stability, and biocompatibility. However, dry electrodes have relatively poor electrical conductance, which is largely influenced by the compact size of the electrode and the variable contact conditions between the electrode and the skin. The equivalent source impedance of a dry electrode may be modeled as a parallel resistance-capacitance (RC) network, with resistance values reaching tens of megaohms (MΩ) and capacitance values in the hundreds of picofarads (pF). Such high source impedance presents challenges for subsequent signal processing, as it can lead to attenuated signals, susceptibility to interference, and/or increased noise levels.

In some embodiments, AFE circuit 102 may be configured to condition the acquired signal before further processing. Given the high source impedance of electrode 101, AFE circuit 102 must exhibit an extremely high input impedance-such as in the gigaohm (GΩ) range-to prevent signal attenuation and distortion. In health sensing applications, given the small signal amplitudes and large DC offsets, AFE circuit 102 may operate with a wide dynamic range (e.g., exceeding 100 dB) to ensure accurate detection of the bio-signal.

In some examples, ADC 103 may be coupled to AFE circuit 102 and configured to convert the conditioned output signal from AFE circuit 102 into a digital representation for further processing. The conversion process may include sampling, quantization, and filtering, ensuring that the digitized data retains the key characteristics of the original input signal. Examples of ADCs may include, without limitation, successive approximation register (SAR) ADCs, pipeline ADCs, delta-sigma ADCs, flash ADCs, and/or the like. In some cases, ADC 103 may be implemented with high resolution and low noise characteristics to preserve signal integrity. For instance, ADC 103 may be implemented as a 24-bit delta-sigma modulator. In practical applications, the power consumption of an ADC is often determined by noise requirements rather than signal bandwidth, meaning that even if the signal frequency remains low, the ADC must still operate with high power to maintain a sufficient dynamic range. This results in substantial energy consumption, especially in multi-channel configurations where multiple ADCs are continuously active.

In various examples, processing unit 104 may be coupled to ADC 103 and configured to receive the digital output signal from ADC 103 and perform various signal processing functions, such as filtering, baseline drift correction, signal normalization, feature extraction, and/or the like. This processing enhances the usability of the acquired bio-signals for downstream applications, such as heart rate monitoring, arrhythmia detection, or other biomedical analyses. Depending on the application, processing unit 104 may be implemented using a digital signal processor (DSP), a microcontroller, an application-specific integrated circuit (ASIC), a general-purpose processor, and/or the like.

While parallel signal acquisition enables continuous and independent sensing, it also introduces challenges related to power consumption and heat dissipation, such as in wearable and battery-powered applications. Each active channel requires its own AFE, ADC, and processing unit, leading to a substantial increase in overall power consumption as the number of channels scales. Additionally, heat dissipation from high-power components may cause localized temperature variations, affecting circuit stability and sensor accuracy. In extreme cases, elevated temperatures may introduce thermal drift in signal acquisition and pose potential bio-safety concerns for prolonged skin contact. Accordingly, there is a need for efficient multi-channel acquisition architectures that minimize power consumption and thermal effects while preserving signal integrity and system performance.

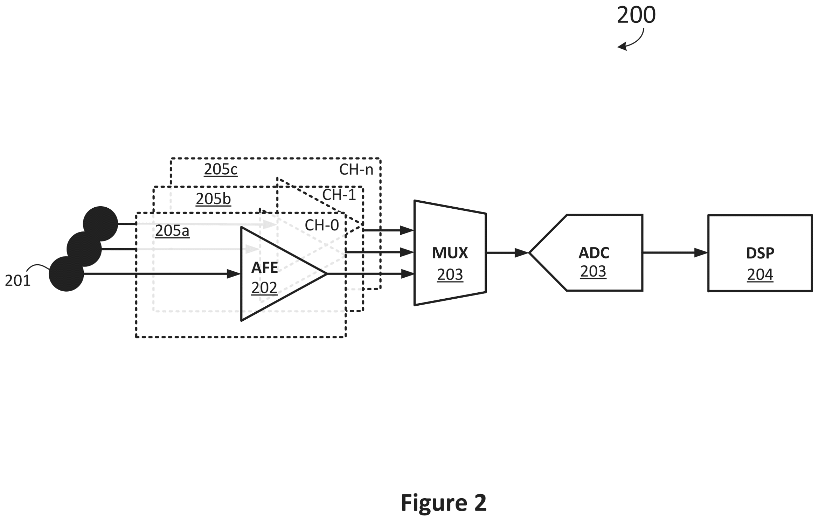

Figure 2 is a block diagram illustrating a multi-channel signal acquisition system employing time-division multiplexing (TDM) 200, in accordance with various embodiments of the subject technology. This diagram merely provides an example, which should not unduly limit the scope of the claims. One of ordinary skill in the art would recognize many variations, alternatives, and modifications. Similar to system 100 of Figure 1, system 200 may be implemented in a wide range of applications that require the acquisition and processing of electrical signals, such as bio-sensing systems, industrial monitoring, environmental sensing, and/or the like. For instance, system 200 may be used to acquire electrophysiological signals from multiple electrodes (e.g., electrode 201) while optimizing power efficiency.

In some implementations, system 200 may utilize time-division multiplexing (TDM) to achieve efficient multi-channel signal acquisition. For example, the term "time-division multiplexing" may refer to a method of transmitting and receiving multiple signals over a single communication channel by dividing the available time into distinct time slots. In a TDM-based system, multiple signal acquisition channels may share a common ADC by sequentially activating one channel at a time while keeping the remaining channels in standby mode. This reduces the number of active ADCs in the system, significantly lowering power consumption and mitigating thermal issues associated with high-power continuous operation.

As shown, system 200 may include a plurality of signal processing channels (e.g., channels 205a, 205b, 205c), each may include an electrode and/or an AFE circuit. For instance, channel 205a (e.g., CH-0) may include electrode 201 and AFE circuit 202. AFE circuit 202 may be configured to condition the acquired signal from electrode 201 before further processing. In some examples, multiplexer (MUX) 203 may be coupled to the outputs of multiple AFE circuits and is configured to select one active channel at a time for signal conversion. By sequentially switching between channels, MUX 203 enables system 200 to acquire signals from multiple sources using a single ADC 203. ADC 203 may then digitize the selected signal, which is subsequently processed by processing unit 204 to extract relevant features, apply filtering, and/or perform other signal-processing tasks.

It is to be appreciated that the TDM configuration in system 200 helps reduce power consumption and minimize thermal dissipation by allowing multiple channels to share a single ADC 203. By keeping only one channel active at a time, system 200 avoids the high-power demands of parallel architectures. However, to fully realize the benefits of TDM, effective power management in standby mode is important, as inefficient transitions between active and standby states can introduce signal artifacts and limit power savings. Therefore, further improvements are needed to reduce standby power and maintain signal integrity during channel switching.

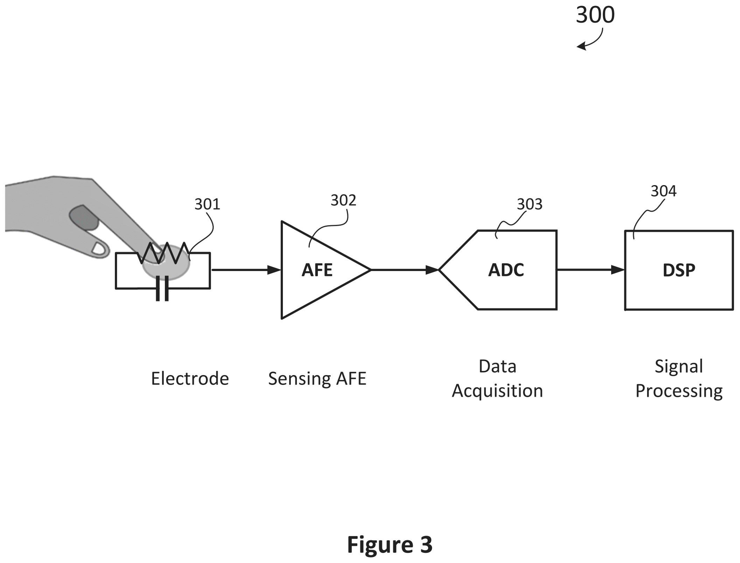

Figure 3 is a block diagram illustrating a signal acquisition system 300, in accordance with various embodiments of the subject technology. This diagram merely provides an example, which should not unduly limit the scope of the claims. One of ordinary skill in the art would recognize many variations, alternatives, and modifications. Similar to system 100 of Figure 1, system 300 may be implemented in a wide range of applications that require the acquisition and processing of electrical signals, such as bio-sensing systems, industrial monitoring, environmental sensing, and/or the like. For instance, system 300 may be used to acquire electrophysiological signals from multiple electrodes (e.g., electrode 301) while optimizing power efficiency.

As shown, system 300 includes at least one of electrode 301, AFE circuit 302, ADC 303, processing unit 304, and/or the like. In some implementations, electrode 301 may be configured to detect electrophysiological signals from a user's body, such as ECG, EEG, or EMG signals. In some cases, electrode 301 may be a dry electrode, which eliminates the need for conductive gels or adhesives. However, dry electrodes have relatively poor electrical conductance, which is influenced by their compact size and the quality of contact with the skin. The high source impedance of electrode 301 presents challenges for subsequent signal acquisition, as it increases susceptibility to noise and interference, which may lead to signal degradation.

To address these challenges, AFE circuit 302 may be configured to condition the acquired bio-signal before further processing. In some examples, AFE circuit 302 may include amplification, filtering, and/or impedance buffering stages to ensure that the weak electrophysiological signal is properly conditioned. Given the high impedance of electrode 301, AFE circuit 302 must exhibit a sufficiently high input impedance and low leakage characteristics to prevent signal attenuation. In some implementations, ADC 303 may be coupled to AFE circuit 302 and configured to convert the conditioned signal into a digital representation. The digitized signal may then be provided to processing unit 304, which may perform various signal processing tasks, such as noise reduction, baseline drift correction, feature extraction, and/or the like.

While system 300 enables bio-signal acquisition using dry electrodes, it is to be appreciated that the high impedance of dry electrodes poses limitations on signal fidelity and system performance. Signal degradation may result from capacitive coupling, environmental noise, motion artifacts and kickbacks from the sensing AFE circuit 302, which can reduce measurement accuracy. Additionally, power consumption in the acquisition path must be minimized to maintain system efficiency, particularly in battery-operated wearable applications. Accordingly, further improvements in AFE design, power management, and signal processing techniques are desirable to enhance the robustness of bio-signal acquisition using dry electrodes.

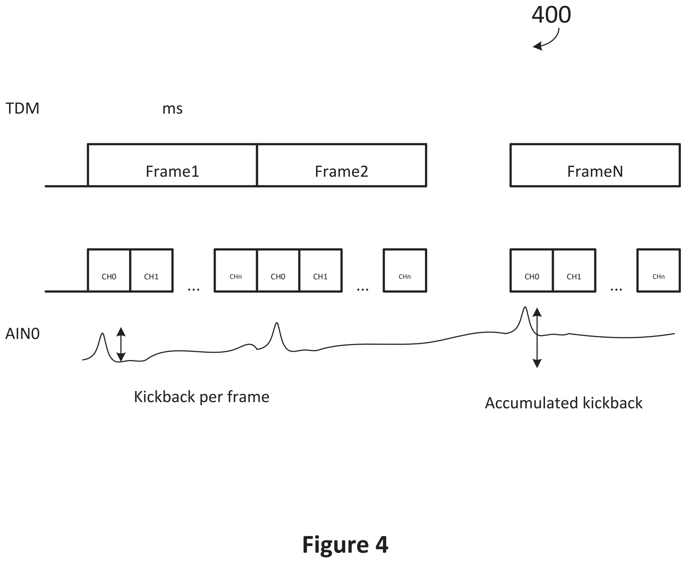

Figure 4 is a simplified diagram illustrating a time-division multiplexing (TDM) operation 400 with kickback effects, in accordance with various embodiments of the subject technology. This diagram merely provides an example, which should not unduly limit the scope of the claims. One of ordinary skill in the art would recognize many variations, alternatives, and modifications.

In various implementations, TDM operation 400 may be performed by a signal acquisition system (e.g., system 200 of Figure 2) to facilitate multi-channel signal acquisition. In some embodiments, TDM operation 400 may be divided into one or more frames (e.g., Frame1, Frame2, FrameN, etc.), where each frame represents a time slot allocated to a specific set of signal acquisition channels. Within each frame, channels (e.g., CH0, CH1, CHn, etc.) may be sequentially activated for signal acquisition, while other channels remain in standby mode.

However, due to the high impedance nature of biosensors (e.g., dry electrodes), the rapid channel switching in a TDM system may introduce kickback effects at the input of the sensing circuit. For instance, the term "kickback" or "kickback effects" may refer to transient voltage disturbances that occur at the input of a signal acquisition circuit when switching between different signal sources or operational states. As shown in Figure 4, each frame transition may introduce kickback noise at the analog input (e.g., AIN0), leading to a short-term perturbation in the acquired signal. In various applications, bio-sensors may exhibit a long recovery time due to their large time constant (e.g., tens to hundreds of milliseconds), any disruption at the input can persist for a significant duration, degrading signal integrity. Given that TDM switching may occur at sub-millisecond speeds, the residual kickback from each frame can accumulate over time, leading to a substantial deviation in signal accuracy.

The accumulated kickback over multiple frames presents challenges in maintaining high-fidelity signal acquisition. If the kickback exhibits signal dependency, a memory effect may arise, leading to image lag and crosstalk between channels. This can introduce artifacts in the acquired bio-signals, reducing the effectiveness of the signal acquisition system. Accordingly, minimizing kickback effects is important to ensure that the performance of a TDM-based system is comparable to that of a parallel sensing architecture. In some implementations, the signal-to-kickback ratio (SKR) must exceed 100 dB to meet the signal-to-noise ratio (SNR) requirements of healthcare sensing applications.

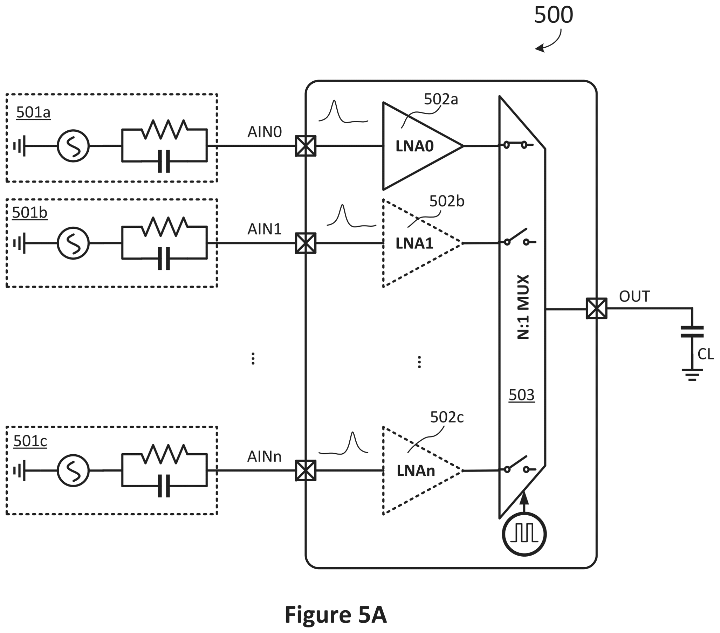

Figure 5A is a circuit diagram illustrating a multi-channel signal acquisition system 500, in accordance with various embodiments of the subject technology. This diagram merely provides an example, which should not unduly limit the scope of the claims. One of ordinary skill in the art would recognize many variations, alternatives, and modifications.

In various implementations, system 500 may include one or more signal acquisition channels to capture signals (e.g., electrophysiological signals) from multiple signal sources (e.g., 501a, 501b, and 501c). Examples of signal sources may include, without limitation, bio-sensors, electrodes, and/or other sensing elements. Each signal source may be coupled to a respective input terminal (e.g., AIN0, AIN1, AINn), which may be configured to receive input signals from single sources. For instance, the term "input terminal" or "input" may refer to a physical or electrical interface within an electronic circuit that is configured to receive an electrical signal or power from an external source. Input terminals may include, without limitation, electrical connectors, pins, pads, ports, sockets, and/or any other physical or virtual interfaces.

In some embodiments, each input terminal (e.g., AIN0, AIN1, AINn) may be coupled to a corresponding amplifier (e.g., amplifiers 502a, 502b, 502c), which may be configured to amplify the acquired input signal for further processing. For example, the term "amplifier" may refer to an electronic circuit that increases the amplitude of an input signal while preserving its key characteristics, such as frequency content and waveform integrity. Examples of amplifiers may include, without limitation, low-noise amplifiers (LNAs), operational amplifiers (op-amps), variable-gain amplifiers (VGAs), and/or the like. In some examples, the outputs of the amplifiers may be multiplexed via MUX 503, which sequentially selects one active channel at a time for output to an external data acquisition circuit (e.g., ADC). In some cases, a capacitor (e.g., CL) may be connected at the output node (e.g., OUT) to stabilize signal transitions and filter out high-frequency noise components. In some cases, CL may also include parasitic capacitance from the PCB traces between the AFE and ADC, as well as the input capacitance of the ADC.

In some implementations, system 500 may employ a TDM scheme, where only one channel is active at a given time while others remain in standby mode. However, as the multiplexed output transitions between different signal acquisition channels, unwanted transient effects-such as kickback noise-may be introduced at the input terminals (e.g., AIN0, AIN1, AINn). For instance, when MUX 503 switches from one channel to another, the amplifier that is switched on may not settle immediately due to bandwidth limitations and slew rate constraints, such as when driving the capacitive load (e.g., CL) at the output. In some cases, this settling behavior can couple to the input through the feedback network around the amplifier.

Additionally, the internal nodes of each amplifier may remain unsettled during transitions between active and standby modes, further contributing to prolonged settling times. The coupling between the output and input nodes-as well as between the internal nodes and the input node-may occur through parasitic capacitance, including non-linear bulk parasitic capacitance of the input transistors, leading to additional kickback-induced distortions. Moreover, switching transients from external circuit traces or board-level interconnections may introduce direct coupling to the input, further compounding the overall kickback effects.

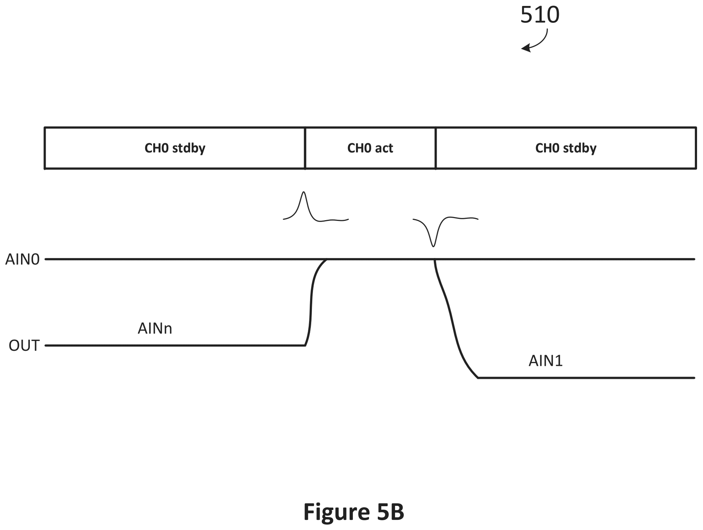

Figure 5B is a simplified diagram illustrating a channel-switching operation 510 in a multi-channel signal acquisition system, in accordance with various embodiments of the subject technology. This diagram merely provides an example, which should not unduly limit the scope of the claims. One of ordinary skill in the art would recognize many variations, alternatives, and modifications.

In various implementations, channel-switching operation 510 may be implemented by a multi-channel signal acquisition system (e.g., system 500 of Figure 5A). When a channel (e.g., CH0) transitions between standby mode (e.g., CH0 stdby) and active mode (e.g., CH0 act), transient effects-such as kickback noise-may occur at the input and/or output nodes. For instance, the term "standby mode" may refer to a low-power operational state in which a circuit remains inactive or partially active while preserving its ability to quickly resume full operation when needed. Depending on the implementation, standby mode may correspond to a low-power state or a complete power-down state. The term "active mode" may refer to a fully operational state in which a circuit is powered on and performing its intended function.

As shown, when CH0 transitions from standby mode to active mode, the corresponding input terminal (e.g., AIN0) may experience a sudden voltage fluctuation because the output node (e.g., OUT), which was set to the voltage of the previous channel (e.g., AINn), may not settle instantaneously to the new corresponding input voltage (e.g., AIN0). The redistribution of charge at the load capacitor (e.g., CL) of the output node (e.g., OUT), as well as at internal nodes and parasitic capacitance coupling within the amplifier (e.g., LNA0), leads to disturbances shown at the input terminal of CH0 (e.g., AIN0). Similarly, when CH0 transitions back to standby mode, the redistribution of charge at internal nodes and parasitic capacitance coupling also leads to disturbances at the input terminal (e.g., AIN0).

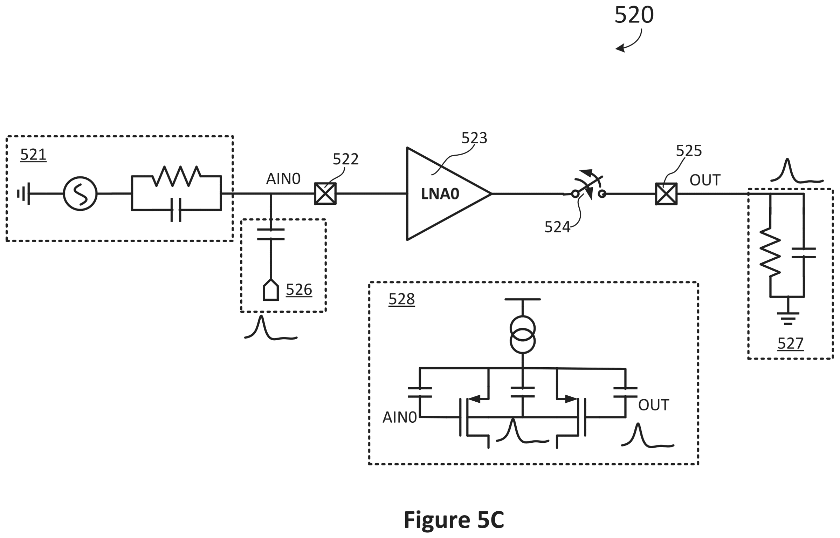

Figure 5C is a circuit diagram illustrating kickback sources in a multi-channel signal acquisition system 520, in accordance with various embodiments of the subject technology. This diagram merely provides an example, which should not unduly limit the scope of the claims. One of ordinary skill in the art would recognize many variations, alternatives, and modifications.

In various embodiments, system 520 may include signal source 521, which may include, without limitation, bio-sensors, electrodes, and/or other sensing elements. Signal source 521 may be configured to detect and generate an electrical signal corresponding to physiological or environmental parameters. For example, in bio-sensing applications, signal source 521 may capture electrophysiological signals such as ECG, EEG, EMG, and/or the like. The generated signal may have a small amplitude and may be susceptible to noise and interference from external sources.

In some examples, signal source 521 may be coupled to input terminal 522, which may be configured to receive an input signal from signal source 521. Amplifier 523 may be coupled to input terminal 522 and configured to amplify the acquired signal before it is passed to the subsequent signal processing stages. In some cases, amplifier 523 may be implemented as an LNA (e.g., with gain in the range of 1x to 100x) to enhance weak signals while preserving their fidelity. In various embodiments, the output of amplifier 523 may be multiplexed through a switching element (e.g., switch 524) before reaching output terminal 525 (e.g., OUT). For instance, the term "output terminal" or "output" may refer to a physical or electrical interface within an electronic circuit that is configured to transmit an electrical signal or power to an external component. Output terminals may include, without limitation, electrical connectors, pins, pads, ports, sockets, and/or any other physical or virtual interfaces. The switching mechanism enables TDM by sequentially selecting different channels for signal acquisition.

However, during channel switching, multiple transient effects may be introduced due to capacitive coupling between circuit nodes. For example, as the multiplexer transitions from one channel to another, output terminal 525 (e.g., OUT) may experience abrupt voltage steps, which may capacitively couple back to input terminal 522 (e.g., AIN0) through various unintended parasitic paths. These parasitic paths may include coupling through the input transistor gate-to-source capacitance and/or bulk-to-source capacitance, as illustrated in amplifier input pair 528, which may be coupled to input terminal 523 and output terminal 525.

In some cases, the capacitive coupling from output terminal 525 to input terminal 522 may induce a transient charge injection, which can disrupt the stability of the input signal and require additional settling time. Furthermore, the non-linear bulk capacitance within amplifier input pair 528 may exacerbate these transient disturbances, leading to undesired signal-dependent artifacts. Within amplifier input pair 528, any internal node that does not settle during switching may further contribute to transient disturbances. If there is capacitive coupling between such internal nodes and the input, the accumulated charge fluctuations can further degrade signal integrity.

According to some examples, system 520 may include a load element (e.g., load 527) coupled to output terminal 525, which may represent any filter cap, PCB trace parasitic, and input capacitance/resistance of the ADC. The presence of load 527 may introduce additional charge redistribution effects when switching occurs. If the output does not fully settle before the next channel is activated, residual voltage fluctuations can be coupled back through amplifier input pair 528, further amplifying the magnitude of the kickback at input terminal 522.

Moreover, additional coupling effects may arise due to board-level traces and interconnections-which may be modeled by capacitor 526-where transient switching events from external circuit elements may induce unwanted disturbances at input terminal 522. These transient effects can degrade signal integrity, introduce noise artifacts, and prolong the settling time of the system. Therefore, minimizing kickback noise and ensuring smooth transitions between active and standby modes are beneficial for achieving high-fidelity signal acquisition in multi-channel architectures.

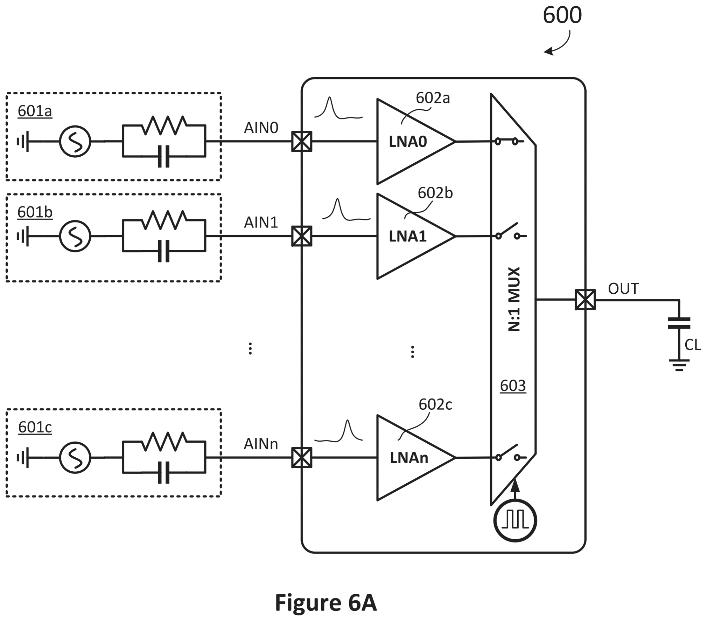

Figure 6A is a circuit diagram illustrating a multi-channel signal acquisition system 600, in accordance with various embodiments of the subject technology. This diagram merely provides an example, which should not unduly limit the scope of the claims. One of ordinary skill in the art would recognize many variations, alternatives, and modifications.

In various implementations, system 600 may include one or more signal acquisition channels to capture signals (e.g., electrophysiological signals) from multiple signal sources (e.g., 601a, 601b, and 601c). Each signal source may be coupled to a respective input terminal (e.g., AIN0, AIN1, AINn), which may be configured to receive input signals from single sources. In some embodiments, each input terminal (e.g., AIN0, AIN1, AINn) may be coupled to a corresponding amplifier (e.g., amplifiers 602a, 602b, 602c), which may be configured to amplify the acquired input signal for further processing.

In some embodiments, system 600 employs an output-switching TDM approach, where all amplifiers remain in active mode, and only the output signal is multiplexed via a switching element (e.g., MUX 603). By keeping all amplifiers active, system 600 minimizes the time required for output signal settling, as the internal nodes of the amplifiers do not need to transition between active and standby states.

In some examples, MUX 603 may be configured to sequentially select the output of each amplifier and route the signal to an external data acquisition system via an output terminal (e.g., OUT). In some cases, a capacitor (e.g., CL) may be connected at the output node (e.g., OUT) to stabilize signal transitions and filter out high-frequency noise components.

While the output switching mechanism reduces settling time by keeping all amplifiers active, it significantly increases power consumption, as all amplifiers remain in active mode continuously. This can be particularly problematic in power-sensitive applications such as wearable bio-sensing devices, where minimizing energy usage is important for battery longevity. The continuous operation of all amplifiers also generates excessive heat, which can lead to temperature drift and signal degradation in bio-sensing applications. In addition, since MUX 603 is in series with the full-swing amplifier output, it can degrade signal integrity and limit total harmonic distortion (THD) performance, making it difficult to achieve a THD above 100dB. Moreover, transient glitches from channel switching may still cause kickback through capacitive coupling, affecting high-impedance input signals. Therefore, while output switching TDM offers advantages in reducing amplifier settling time, it comes with trade-offs in power efficiency, signal distortion, and kickback suppression, necessitating further optimizations to improve overall system performance.

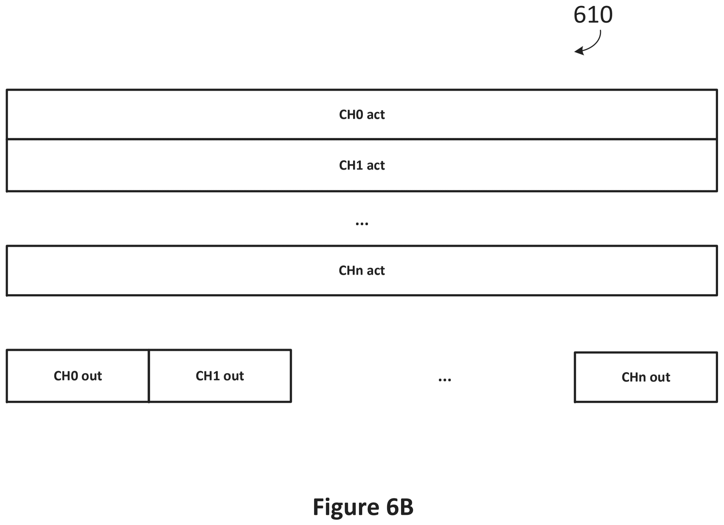

Figure 6B is a simplified diagram illustrating an output switching operation 610 in a multi-channel signal acquisition system, in accordance with various embodiments of the subject technology. This diagram merely provides an example, which should not unduly limit the scope of the claims. One of ordinary skill in the art would recognize many variations, alternatives, and modifications.

In various implementations, output switching operation 610 may be performed by a multi-channel signal acquisition system (e.g., system 600 of Figure 6A). As shown, each channel (e.g., CH0, CH1, CHn, etc.) remains in an active state while only the corresponding output (e.g., CH0 out, CH1 out, CHn out) is switched at a given time. This configuration allows the system to maintain a continuous amplification process without requiring power mode transitions in the amplifiers, thereby reducing output settling delays. However, keeping all amplifiers active results in significantly high-power consumption, making this approach less suitable for power-sensitive applications such as wearable biosensors. Additionally, switching at the output node introduces transient glitches that may propagate through capacitive coupling, causing kickback effects that can degrade signal integrity and affect high-impedance input signals.

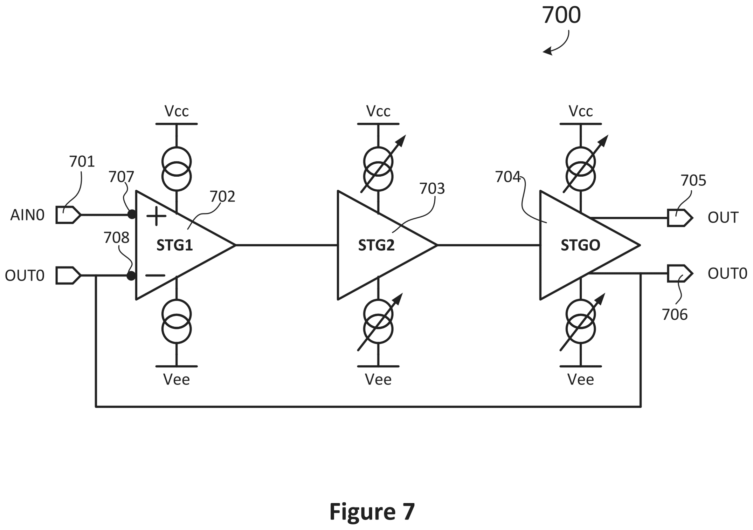

Figure 7 is a circuit diagram illustrating an amplifier 700, in accordance with various embodiments of the subject technology. This diagram merely provides an example, which should not unduly limit the scope of the claims. One of ordinary skill in the art would recognize many variations, alternatives, and modifications.

In various implementations, amplifier 700 may be part of an AFE circuit (e.g., AFE circuit 302 of Figure 3) and configured to condition and amplify weak analog signals before further processing. In some embodiments, amplifier 700 may be implemented as a multi-stage, multi-power-mode amplifier configured to minimize kickback effects and standby power consumption. As an example, system 700 may include at least one of first stage 702, second stage 703, third stage 704, and/or other amplification stages, depending on the implementation. For instance, the term "stage" may refer to an electronic circuit that performs a specific operation such as voltage gain, buffering, filtering, impedance matching, and/or the like. These stages may work together to facilitate stable signal amplification during TDM operations. In some examples, amplifier 700 may operate in coordination with one or more amplifiers in a multi-channel TDM system, where different channels are sequentially activated for signal acquisition. During TDM operation, amplifier 700 may transition between active and standby modes based on control signals that determine the currently selected channel.

In some embodiments, system 700 includes input terminal 701 (e.g., AIN0), which may be configured to receive an input signal. Examples of input signals may include, without limitation, electrophysiological signals, industrial monitoring signals, environmental sensor data, and/or the like. For instance, the input signal may include a low-amplitude bio-signal that requires precise amplification with minimal noise interference to ensure accurate data acquisition. In some examples, first stage 702 may include first input 707 and second input 708. As an example, first stage 702 may receive a differential input pair, where first input 707 corresponds to a non-inverting input and second input 708 corresponds to an inverting input.

In various implementations, first stage 702 may be configured to receive a first bias current. For instance, the term "bias current" may refer to a steady-state current applied to a circuit element to establish its operating condition. Bias currents may be used to set the operating point of active components, regulate transistor conduction states, and stabilize circuit behavior. As an example, first stage 702 may be designed to remain continuously on with a constant bias, ensuring a stable operating point regardless of active or standby mode transitions in the subsequent stages. For instance, first stage 702 may be coupled between a positive supply voltage (e.g., Vcc) and a negative supply voltage (e.g., Vee) to maintain consistent operation. The constant biasing prevents abrupt voltage shifts that could otherwise introduce kickback noise into the system, particularly during power mode switching. Additionally, first stage 702 provides initial voltage gain, which helps attenuate power mode switching transients from subsequent stages (e.g., second stage 703 and third stage 704). By maintaining a steady operating condition independent of power state transitions, first stage 702 enhances overall amplifier stability and signal integrity, ensuring smooth transitions between active and standby modes while reducing unwanted interference at the input.

According to some embodiments, second stage 703 may be coupled to first stage 702, and third stage 704 may be coupled to second stage 703. In some examples, second stage 703 and third stage 704 may be configured to operate in multiple power modes to support channel switching during TDM operation. In some cases, second stage 703 and third stage 704 may be characterized by a first state associated with a first power level and a second state associated with a second power level. For instance, the term "state" may refer to an operational mode of a circuit block that determines its functionality, such as active mode, standby mode, power-down mode, and/or the like. The term "power level" may refer to the amount of electrical power consumed during a given state, which may include, for example, a full-power condition, a reduced-power state, a power-down condition, and/or the like. Depending on the implementation, amplifier 700 may transition between these states based on a control signal (e.g., timing control signal or channel selection signal) to optimize overall power efficiency.

As an example, second stage 703 and third stage 704 may be selectively transitioned between an active mode and a standby mode depending on control signals that determine the active acquisition channel. In the standby mode, second stage 703 and third stage 704 may enter a low-power mode by reducing the bandwidth of the amplifier and/or disconnecting the amplifier from the output load. In some cases, second stage 703 and/or third stage 704 may be configured to receive a bias current based at least on the control signal. Depending on the implementation, the bias current applied to second stage 703 and/or third stage 704 may be fixed or programmable, allowing precise control over power consumption based on performance requirements or system conditions.

In some implementations, third stage 704 may include first output 705 (e.g., OUT) and second output 706 (e.g., OUTO). For instance, first output 705 may be configured to drive the output signal to a shared ADC input across all TDM channels. To prevent signal contention, only the main output (e.g., first output 705) of the currently active channel is enabled, while the first outputs of all other channels are placed in a high-impedance (e.g., high-Z) state. This ensures that only one signal path is active at any given time during the TDM scan cycle, enabling precise time-multiplexed sampling by the ADC.

In some embodiments, second output 706 may be coupled to an input (e.g., second input 708) of first stage 702. Second output 706 may be configured to provide a local feedback signal to first stage 702 and remain active in both the active and standby modes. By maintaining a continuous feedback path from internal output 706 to the input stage, amplifier 700 ensures that the operating point of first stage 702 remains undisturbed regardless of the switching activity at the main output (e.g., first output 705). The separation of internal and external outputs allows amplifier 700 to maintain linearity and input stability during channel switching, supporting efficient TDM operation with minimal power consumption and improved signal fidelity.

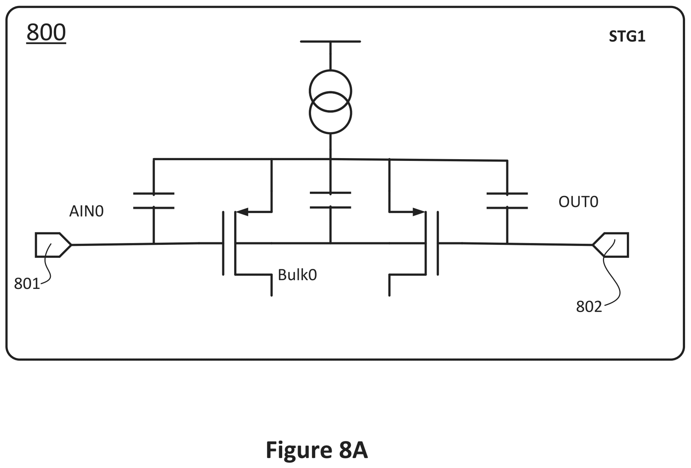

Figure 8A is a circuit diagram illustrating a first stage 800 of an amplifier, in accordance with various embodiments of the subject technology. This diagram merely provides an example, which should not unduly limit the scope of the claims. One of ordinary skill in the art would recognize many variations, alternatives, and modifications.

In various implementations, first stage 800 may be an input stage of an amplifier (e.g., amplifier 700 of Figure 7) and configured to provide initial amplification to an input signal. For instance, first stage 800 may receive an input signal at input terminal 801 (e.g., AIN0) and generate an amplified signal at output terminal 802 (e.g., OUTO). In some embodiments, first stage 800 may include a differential input transistor pair whose bulk region (e.g., Bulk0) is biased using the always-on output (e.g., OUTO) with additional voltage offset. The bulk biasing helps mitigate kickback effects caused by non-linear capacitive coupling between the gate and the body of the input transistors, thereby improving input signal integrity. In some cases, output terminal 802 may serve as an internal node that remains continuously connected to the amplifier feedback network to ensure a stable biasing condition for the bulk, reducing transient disturbances during channel switching.

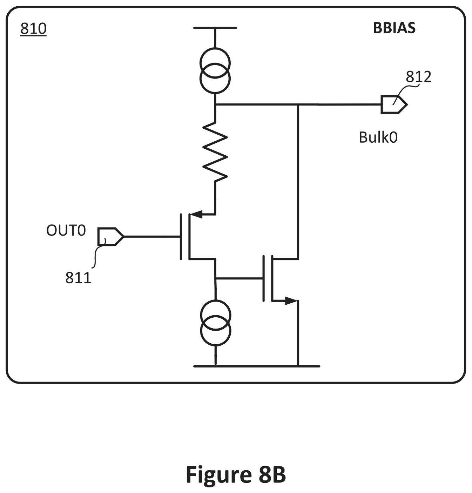

Figure 8B is a circuit diagram illustrating a biasing circuit 810 of a first stage, in accordance with various embodiments of the subject technology. This diagram merely provides an example, which should not unduly limit the scope of the claims. One of ordinary skill in the art would recognize many variations, alternatives, and modifications. In various implementations, biasing circuit 810 may be part of an amplifier (e.g., first stage 800 of Figure 8A) and configured to provide a stable bulk bias voltage with minimal kickback effects. For example, biasing circuit 810 may be implemented as a level-shifting voltage buffer and configured to regulate the bulk voltage of the input transistors in first stage 800.

In some embodiments, biasing circuit 810 may receive a reference voltage (e.g., derived from OUT0 at terminal 811) and generate a bulk bias voltage at terminal 812 (e.g., Bulk0). For example, terminal 812 may be coupled to the bulk nodes of the input differential pair in first stage 800 and configured to ensure that these nodes remain in a controlled bias condition. Biasing circuit 810 generate an output 812 that tracks its input 811, with a fixed voltage offset determined by the VGS of the PMOS, the resistor and the bias current. This ensures a constant voltage between Bulk0 (e.g., bulk of the input transistors in 800) and OUT0 (e.g., gate of the input transistors in 800). By maintaining a constant bulk to gate voltage, biasing circuit 810 helps mitigate nonlinear capacitive coupling between the gate and body of the input transistors, reducing unwanted transient disturbances that could degrade signal integrity. The bulk bias voltage may be derived from the always-on internal node (e.g., OUT0), ensuring that it remains stable regardless of channel switching activity at the main amplifier output (e.g., OUT). In some cases, biasing circuit 810 may employ a power-efficient super source follower, which extends the biasing circuit bandwidth while maintaining low power consumption.

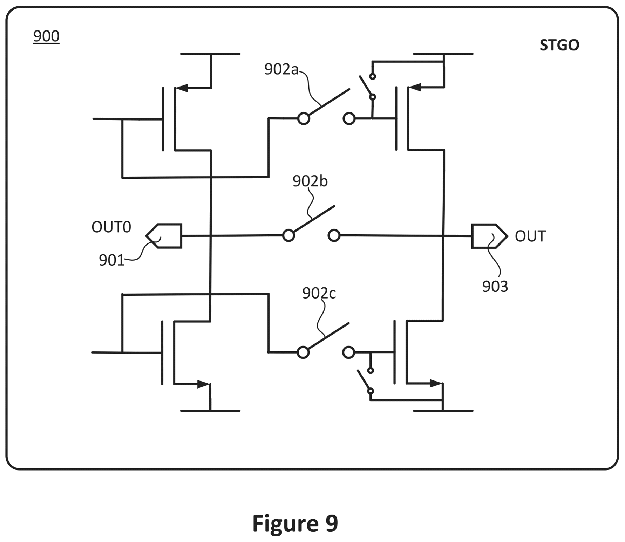

Figure 9 is a circuit diagram illustrating a third stage 900 of an amplifier, in accordance with various embodiments of the subject technology. This diagram merely provides an example, which should not unduly limit the scope of the claims. One of ordinary skill in the art would recognize many variations, alternatives, and modifications. In various implementations, third stage 900 may be an output stage of an amplifier (e.g., amplifier 700 of Figure 7) and configured to provide output signal buffering and/or output switching. For example, third stage 900 may operate in conjunction with preceding amplification stages (e.g., first stage 702 and second stage 703 of Figure 7) to facilitate TDM signal acquisition.

In some embodiments, third stage 900 may include first output 903 (e.g., OUT) and second output 901 (e.g., OUTO). For instance, first output 903 may be coupled to a shared ADC input across multiple channels and configured to transmit the amplified signal from the currently active channel during TDM operation. Second output 901 may be internally connected to provide local feedback to stabilize the amplifier's operating point. By maintaining an always-on internal output path, third stage 900 ensures stable biasing conditions for preceding stages, minimizing disturbances caused by channel switching.

In some examples, switches 902a, 902b, and 902c may be configured to control which channel is connected to the ADC at any given time. These switches selectively route the active channel's output to first output terminal 903 while keeping all other channels in a high-impedance state to prevent signal contention. For example, when a particular channel is selected, the corresponding switches may close to establish the signal path, while the switches associated with inactive channels remain open, effectively isolating them from the shared output.

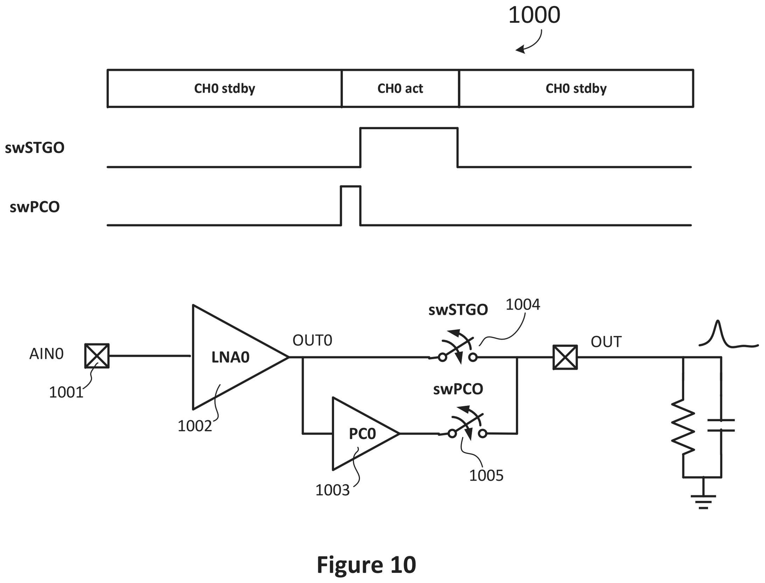

Figure 10 is a circuit diagram illustrating an amplifier system with a pre-charging buffer 1000, in accordance with various embodiments of the subject technology. This diagram merely provides an example, which should not unduly limit the scope of the claims. One of ordinary skill in the art would recognize many variations, alternatives, and modifications.

In various implementations, system 1000 may be part of an AFE circuit (e.g., AFE circuit 302 of Figure 3) and configured to condition and amplify weak analog signals before further processing. As shown, system 1000 may include input terminal 1001 (e.g., AIN0), which may be configured to receive an input signal. For instance, the input signal may include a low-amplitude bio signal that requires precise amplification with minimal noise interference to ensure accurate data acquisition. Amplifier 1002 may be coupled to input terminal 1001 and configured to condition and amplify the input signal for further processing.

In various examples, amplifier 1002 may include a first output (e.g., OUT) and a second output (e.g., OUTO). For example, the first output (e.g., OUT) may serve as a main output and be configured to drive the output signal to a shared ADC input across multiple TDM channels. The second output (e.g., OUTO) may serve as an internal output configured to maintain continuous feedback to the amplifier's input stage, ensuring a stable operating point.

In some cases, system 1000 may include switch 1004 (e.g., swSTGO) coupled to the first output (e.g., OUT). For instance, switch 1004 may be configured to selectively connect or disconnect the first output from the shared output bus (e.g., a shared ADC line), depending on the channel activation. When enabled, switch 1004 connects the amplifier's main output to the ADC; when disabled, it isolates the amplifier's main output to prevent interference with other channels.

In some embodiments, system 1000 may further include buffer 1003 and/or switch 1005 (e.g., swPCO) coupled to the first output (e.g., OUT) and the second output (e.g., OUTO) of amplifier 1002. For example, the term "buffer" may refer to an electronic circuit or component used to isolate and/or stabilize a signal while maintaining its integrity. Examples of buffers may include, without limitation, voltage followers, unity-gain buffers, source followers, and/or the like.

In some implementations, buffer 1003 may function as a pre-charge buffer and be configured to pre-charge the amplifier's main output node (e.g., OUT) to a voltage level close to the internal output node (e.g., OUTO) prior to activation of the main amplifier output. For example, the term "voltage level" may refer to an electrical potential at a certain node in a circuit, which may be fixed, variable, or dependent on other circuit conditions.

During pre-charging, switch 1005 is enabled, allowing buffer 1003 to temporarily drive the main output node (e.g., OUT), thereby reducing the output voltage differential and minimizing transient disturbances when the amplifier output is subsequently activated. In some cases, buffer 1003 may be placed outside the main amplifier feedback loop, providing isolation that prevents output glitches from propagating back into amplifier 1002, thus reducing kickback noise and enhancing signal integrity during channel transitions.

In operation, as illustrated in the timing diagram of Figure 10, system 1000 may transition through various operational states including a standby mode (e.g., CH0 stdby) and an active mode (e.g., CH0 act). Initially, when the channel is in standby mode, switch 1004 (e.g., swSTGO) and switch 1005 (e.g., swPCO) remain open, isolating amplifier 1002 and buffer 1003 from the first output. Prior to entering the active mode, switch 1005 (e.g., swPCO) momentarily closes, allowing buffer 1003 to pre-charge the first output (e.g., OUT) to a voltage close to the second output (e.g., OUTO). After the pre-charge period, switch 1005 opens, and switch 1004 (e.g., swSTGO) closes, allowing amplifier 1002 to drive the fully conditioned output signal onto the shared ADC line. The pre-charged output voltage minimizes the amplitude of voltage changes required from the main amplifier, thereby reducing the settling time and suppressing output glitches and kickback noise to the input.

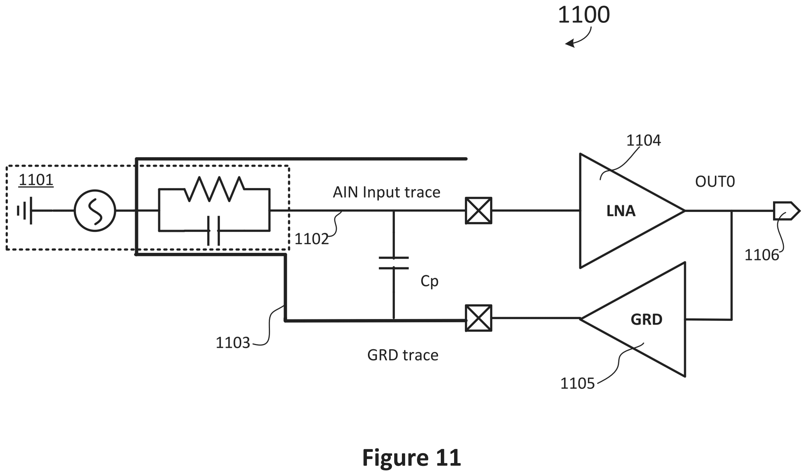

Figure 11 is a circuit diagram illustrating an analog front-end (AFE) circuit 1100 with a guard buffer, in accordance with various embodiments of the subject technology. This diagram merely provides an example, which should not unduly limit the scope of the claims. One of ordinary skill in the art would recognize many variations, alternatives, and modifications.

In some embodiments, AFE circuit 1100 may include signal source 1101, which may be configured to detect weak analog signals such as bio-signals in electrophysiological applications. The received signal may be transmitted along input trace 1102 to amplifier 1104 for amplification. The amplified signal is then transmitted to output terminal 1106, which serves as the interface for downstream signal processing stages. However, due to proximity to switching signals and surrounding PCB traces (e.g., guard trace 1103), input trace 1102 may be susceptible to disturbance caused by parasitic capacitive coupling (e.g., Cp) from chip-level or board-level switching nodes.

To address these issues, AFE circuit 1100 may further include buffer 1105, which may be configured to provide isolation between the input terminal and external components. For instance, buffer 1105 may act as a guard buffer and be configured to drive guard trace 1103 to minimize voltage differentials across the parasitic capacitance (e.g., Cp). For instance, buffer 1105 may be configured to maintain the voltage potential of guard trace 1103 substantially equal to the input trace 1102, thereby reducing capacitive coupling and minimizing disturbances from switching nodes. By driving guard trace 1103 at a voltage level closely matching input trace 1102, AFE circuit 1100 ensures that the capacitive coupling pathways remain effectively neutralized.

While the above is a full description of the specific embodiments, various modifications, alternative constructions and equivalents may be used. Therefore, the above description and illustrations should not be taken as limiting the scope of the subject technology which is defined by the appended claims.

The following are further embodiments of the present invention:
1. An apparatus comprising:
   an input terminal configured to receive an input signal;
   a first stage comprising a first input and a second input, the first input being coupled to the input terminal, the first stage being configured to receive a first bias current;
   a second stage coupled to the first stage, the second stage being characterized by a first state and a second state, the first state being associated with a first power level, the second state being associated with a second power level, the second power level being lower than the first power level; and
   a third stage coupled to the second stage, the third stage comprising a first output and a second output, the second output being coupled to the second input, the first output being configured to provide an output signal based at least on the input signal, the third stage being characterized by the first state and the second state;
   wherein the second stage and the third stage are configured to transition between the first state and the second state in response to a control signal.
2. The apparatus of embodiment 1, wherein the first stage comprises a first bias circuit configured to generate the first bias current based at least on a reference voltage.
3. The apparatus of embodiment 1, wherein the second stage is configured to receive a first bias current based at least on the control signal.
4. The apparatus of embodiment 1, further comprising a first buffer coupled to the first output and the second output, the second output being characterized by a first voltage level, the first buffer being configured to charge the first output to the first voltage level before a transition between the first state and the second state.
5. The apparatus of embodiment 1, further comprising a second buffer coupled to the input terminal, the second buffer being configured to provide isolation between the input terminal and external components.
6. The apparatus of embodiment 1, wherein the first output is coupled to an analog-to-digital converter (ADC).
7. An apparatus comprising:
   an input terminal configured to receive an input signal;
   a first stage comprising a first input and a second input, the first input being coupled to the input terminal, the first stage being configured to receive a first bias current;
   a second stage coupled to the first stage, the second stage being characterized by a first state and a second state, the first state being associated with a first power level, the second state being associated with a second power level; and
   a third stage coupled to the second stage, the third stage comprising a first output and a second output, the second output being coupled to the second input, the first output being configured to provide an output signal based at least on the input signal, the third stage being characterized by the first state and the second state.
8. The apparatus of embodiment 7, wherein the second stage and the third stage are configured to transition between the first state and the second state in response to a control signal.
9. The apparatus of embodiment 7, wherein the second power level is lower than the first power level.
10. The apparatus of embodiment 7, wherein the first stage comprises a first bias circuit configured to generate the first bias current based at least on a reference voltage.
11. The apparatus of embodiment 7, further comprising a first buffer coupled to the first output and the second output, the second output being characterized by a first voltage level, the first buffer being configured to charge the first output to the first voltage level before a transition between the first state and the second state.
12. The apparatus of embodiment 7, further comprising a second buffer coupled to the input terminal, the second buffer being configured to provide isolation between the input terminal and external components.
13. The apparatus of embodiment 7, wherein the first output is coupled to an analog-to-digital converter (ADC).
14. An apparatus comprising:
   an input terminal configured to receive an input signal;
   a first stage comprising a first input, the first input being coupled to the input terminal, the first stage being configured to receive a first bias current;
   a second stage coupled to the first stage, the second stage being characterized by a first state and a second state, the first state being associated with a first power level, the second state being associated with a second power level, the second power level being lower than the first power level; and
   a third stage coupled to the second stage, the third stage comprising a first output configured to provide an output signal based at least on the input signal, the third stage being characterized by the first state and the second state.
15. The apparatus of embodiment 14, wherein the first stage further comprises a second input, the third stage further comprises a second output, the second output is coupled to the second input and configured to provide a feedback signal to the second input.
16. The apparatus of embodiment 14, wherein the second stage is configured to transition between the first state and the second state in response to a control signal.
17. The apparatus of embodiment 16, wherein the second stage is configured to receive a first bias current based at least on the control signal.
18. The apparatus of embodiment 14, wherein the first stage comprises a first bias circuit configured to generate the first bias current based at least on a reference voltage.
19. The apparatus of embodiment 14, further comprising a first buffer coupled to the first output and the second output, the second output being characterized by a first voltage level, the first buffer being configured to charge the first output to the first voltage level before a transition between the first state and the second state.
20. The apparatus of embodiment 14, further comprising a second buffer coupled to the input terminal, the second buffer being configured to provide isolation between the input terminal and external components.

## Claims

1. An apparatus comprising:
an input terminal configured to receive an input signal;
a first stage comprising a first input and a second input, the first input being coupled to the input terminal, the first stage being configured to receive a first bias current;
a second stage coupled to the first stage, the second stage being **characterized by** a first state and a second state, the first state being associated with a first power level, the second state being associated with a second power level; and
a third stage coupled to the second stage, the third stage comprising a first output and a second output, the second output being coupled to the second input, the first output being configured to provide an output signal based at least on the input signal, the third stage being **characterized by** the first state and the second state.

2. The apparatus of claim 1, wherein the second stage and the third stage are configured to transition between the first state and the second state in response to a control signal.

3. The apparatus of claim 1 or claim 2, wherein the second power level is lower than the first power level.

4. The apparatus of any of the preceding claims, wherein the first stage comprises a first bias circuit configured to generate the first bias current based at least on a reference voltage.

5. The apparatus of any of the preceding claims, wherein the second stage is configured to receive a first bias current based at least on the control signal.

6. The apparatus of any of the preceding claims, further comprising a first buffer coupled to the first output and the second output, the second output being **characterized by** a first voltage level, the first buffer being configured to charge the first output to the first voltage level before a transition between the first state and the second state.

7. The apparatus of any of the preceding claims, further comprising a second buffer coupled to the input terminal, the second buffer being configured to provide isolation between the input terminal and external components.

8. The apparatus of any of the preceding claims, wherein the first output is coupled to an analog-to-digital converter (ADC).

9. An apparatus comprising:
an input terminal configured to receive an input signal;
a first stage comprising a first input, the first input being coupled to the input terminal, the first stage being configured to receive a first bias current;
a second stage coupled to the first stage, the second stage being **characterized by** a first state and a second state, the first state being associated with a first power level, the second state being associated with a second power level, the second power level being lower than the first power level; and
a third stage coupled to the second stage, the third stage comprising a first output configured to provide an output signal based at least on the input signal, the third stage being **characterized by** the first state and the second state.

10. The apparatus of claim 9, wherein the first stage further comprises a second input, the third stage further comprises a second output, the second output is coupled to the second input and configured to provide a feedback signal to the second input.

11. The apparatus of claim 9 or claim 10, wherein the second stage is configured to transition between the first state and the second state in response to a control signal.

12. The apparatus of any of claims 9 to 11, wherein the second stage is configured to receive a first bias current based at least on the control signal.

13. The apparatus of any of claims 9 to 12, wherein the first stage comprises a first bias circuit configured to generate the first bias current based at least on a reference voltage.

14. The apparatus of any of claims 9 to 13, further comprising a first buffer coupled to the first output and the second output, the second output being **characterized by** a first voltage level, the first buffer being configured to charge the first output to the first voltage level before a transition between the first state and the second state.

15. The apparatus of any of claims 9 to 14, further comprising a second buffer coupled to the input terminal, the second buffer being configured to provide isolation between the input terminal and external components.
